# EUROPEAN PATENT APPLICATION

(11) **EP 4 804 766 A1**
(43) Date of publication of application: **09.09.2026**
(21) Application number: 24883624.9
(22) Date of filing: 07.11.2024
(51) Int. Cl.: H10F 39/18, H10F 30/20

(54) **PHOTOELECTRIC CONVERSION DEVICE**

(30) Priority: 08.11.2023 JP 2023190608
(71) Applicant: NATIONAL UNIVERSITY CORPORATION SHIZUOKA UNIVERSITY, Shizuoka-shi, Shizuoka 422-8529 (JP)
(72) Inventor: KAWAHITO Shoji, Hamamatsu-shi, Shizuoka 432-8561 (JP)
(74) Representative: Wittmer, Maximilian
(86) International application number: PCT/JP2024/039686
(87) International publication number: WO 2025/100501

(57) **Abstract**

A photoelectric conversion device 1 includes a semiconductor substrate 3 and a photoelectric conversion layer 4, and the photoelectric conversion layer 4 includes: an N-type buried region n1B configured to convert a blue light component incident on a main surface 4b into electrons and accumulate the electrons; an N-type buried region n3G configured to convert a green light component incident on the main surface 4b into electrons; an N-type buried region n1G configured to accumulate the electrons after the conversion process of the buried region n3G; and an N-type buried region n2G configured to come into contact with the buried region n3G and the buried region n1G and provided to be sandwiched between two P-type regions between the buried region n3G and the buried region n1G, the buried region n2G transferring the electrons after the conversion process of the buried region n3G to the buried region n1G, wherein an impurity concentration of the buried region n1G is set to be higher than an impurity concentration of the buried region n2G, and an impurity concentration of the buried region n2G is set to be higher than an impurity concentration of the buried region n3G.

## Description

### Technical Field

The present disclosure relates to a photoelectric conversion device.

### Background Art

In recent years, color image sensors utilizing a property that a light absorption coefficient in a semiconductor such as silicon varies with a depth direction have been becoming widespread. In a photoelectric conversion element described in the following Patent Literature 1, three photoelectric conversion units are formed at positions having different depths in a semiconductor layer, and three signal charge accumulation units for accumulating signal charges generated in the respective photoelectric conversion units are formed on a surface of the semiconductor layer.

### Citation List

### Patent Literature

[Patent Literature 1] Japanese Unexamined Patent Publication No. 2003-298038
[Patent Literature 2] Japanese Unexamined Patent Publication No. 2007-531254

### Summary of Invention

### Technical Problem

In the conventional photoelectric conversion element as described above, there has been a limitation in increasing a speed at which signal charges are transferred from a photoelectric conversion unit to a signal charge accumulation unit. As a result, it has tended to be difficult to increase the speed of signal charge detection.

The present disclosure has been made in view of the above-described problem and an objective thereof is to provide a photoelectric conversion device capable of realizing high-speed signal charge detection.

### Solution to Problem

According to an aspect of the present invention for solving the above problem, there is provided a photoelectric conversion device comprising: a semiconductor substrate; and a photoelectric conversion layer formed on the semiconductor substrate and having a first main surface close to the semiconductor substrate and a second main surface extending along the first main surface, wherein the photoelectric conversion layer includes: a first buried region of a first conductivity type buried at the second main surface and configured to convert light of a first wavelength component incident on the second main surface into carriers and accumulate the carriers after the conversion; a second buried region of the first conductivity type buried at a position deeper than the first buried region from the second main surface and configured to convert light of a second wavelength component incident on the second main surface into carriers; a third buried region of the first conductivity type buried in the same layer as the first buried region at the second main surface and configured to accumulate carriers obtained by a conversion process of the second buried region; and a fourth buried region of the first conductivity type configured to come into contact with the second buried region and the third buried region and provided to be sandwiched between two regions of a second conductivity type between the second buried region and the third buried region, the fourth buried region being configured to transfer the carriers obtained by the conversion process of the second buried region to the third buried region, wherein an impurity concentration of the third buried region is set to be higher than an impurity concentration of the fourth buried region, and an impurity concentration of the fourth buried region is set to be higher than an impurity concentration of the second buried region.

According to the photoelectric conversion device of the above-described form, among the components of light incident from the second main surface of the photoelectric conversion layer, the first wavelength component is converted into carriers in the first buried region of the first conductivity type, and the carriers after the conversion are accumulated. In addition, among the components of light incident from the second main surface of the photoelectric conversion layer, the second wavelength component is converted into carriers in the second buried region of the first conductivity type, and the carriers after the conversion are accumulated in the third buried region of the first conductivity type via the fourth buried region of the first conductivity type that is in contact with the second buried region and the third buried region. Here, the fourth buried region is sandwiched by two regions of the second conductivity type, and the impurity concentration is set to increase in the order of the second buried region, the fourth buried region, and the third buried region. Thereby, in the potential distribution along the carrier transfer path from the second buried region to the third buried region, a potential dip is less likely to occur, and a potential that changes monotonically is formed, such that carriers can be transferred at high speed from the second buried region to the third buried region. As a result, it becomes possible to realize high-speed detection of carriers accumulated in accordance with light of two wavelength components.

### Advantageous Effects of Invention

According to the present disclosure, high-speed signal charge detection can be realized.

### Brief Description of Drawings

FIG. 1 is a plan view of a photoelectric conversion device 1 according to an embodiment.
FIG. 2 is a cross-sectional view taken along a line connecting points G', G, B, F, and F' of the photoelectric conversion device 1 shown in FIG. 1.
FIG. 3 is a cross-sectional view taken along a line connecting points E and E' of the photoelectric conversion device 1 shown in FIG. 1.
FIG. 4 is a graph showing a potential distribution in a depth direction in a pixel structure 2 shown in FIG. 2.
FIG. 5 is a graph showing a potential distribution in the depth direction in the pixel structure 2 shown in FIG. 2.
FIG. 6 is a cross-sectional view of a pixel structure 2A according to a modification example.
FIG. 7 is a plan view of a photoelectric conversion device 1A according to a modification example.
FIG. 8 is a cross-sectional view taken along a line connecting points G', G, B, F, and F' of the photoelectric conversion device 1A shown in FIG. 7.
FIG. 9 is a cross-sectional view taken along a line connecting points G', G, B, F, and F' of a photoelectric conversion device according to another modification example.

### Description of Embodiments

Hereinafter, preferred embodiments of a photoelectric conversion device according to the present disclosure will be described in detail with reference to the drawings. In the description of the drawings, identical or corresponding parts are denoted by the same reference signs, and redundant descriptions thereof will be omitted.

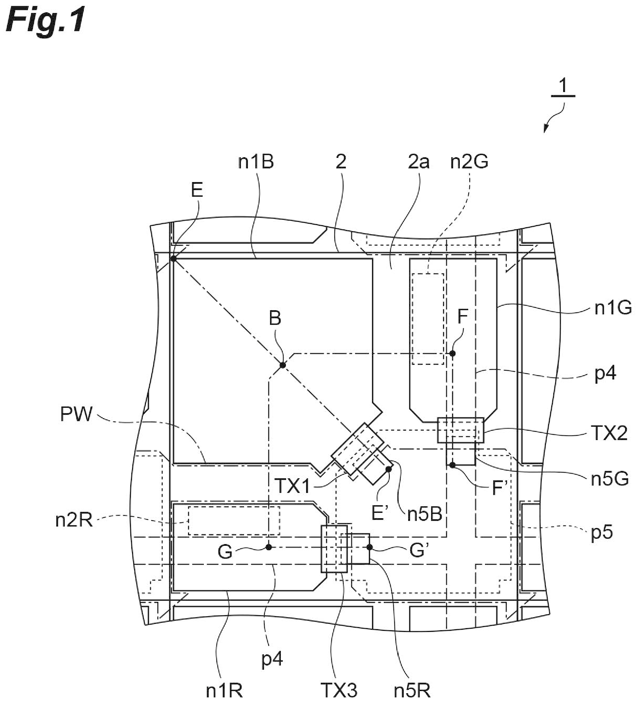

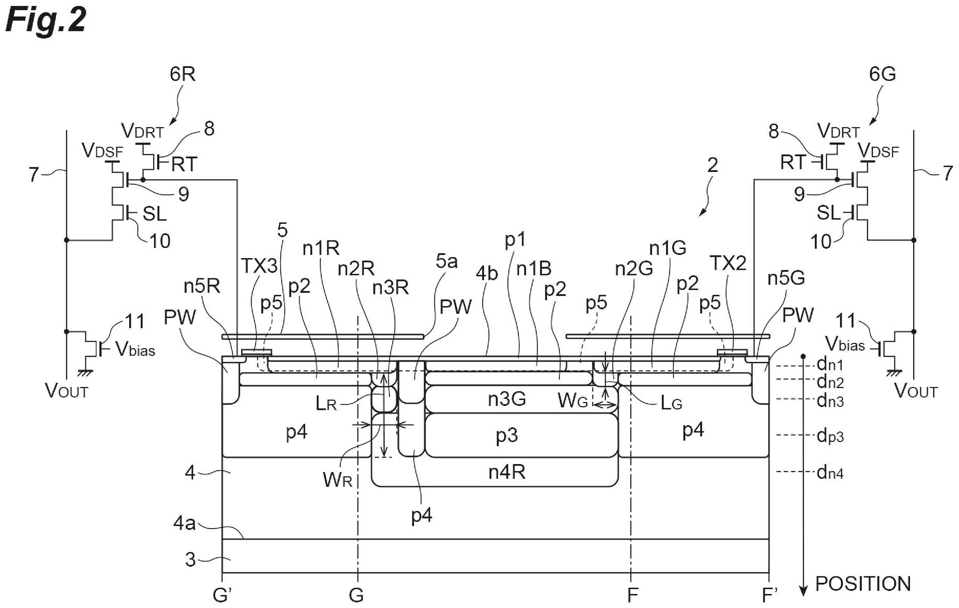

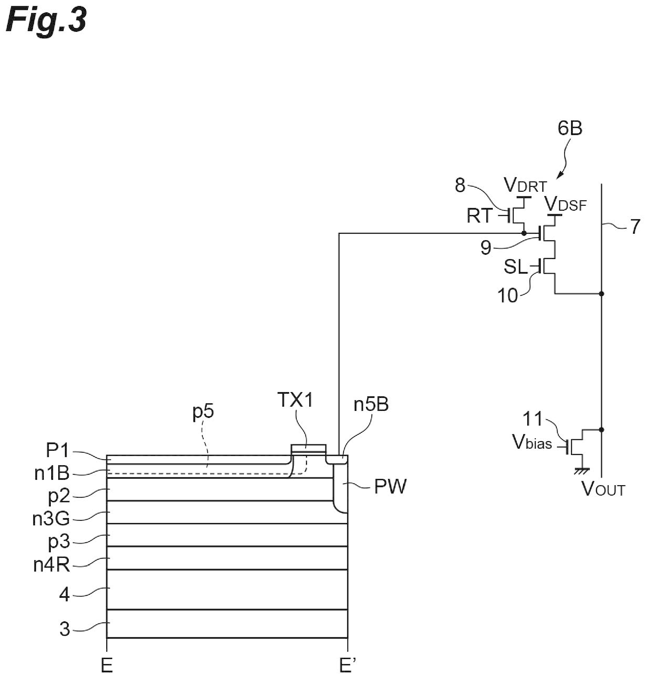

First, a configuration of a photoelectric conversion device 1 according to an embodiment of the present disclosure will be described with reference to FIGS. 1 to 3. FIG. 1 is a plan view of the photoelectric conversion device 1, FIG. 2 is a cross-sectional view taken along a line connecting points G', G, B, F, and F' of the photoelectric conversion device 1 shown in FIG. 1, and FIG. 3 is a cross-sectional view taken along a line connecting points E and E' of the photoelectric conversion device 1 shown in FIG. 1. The photoelectric conversion device 1 is a solid-state imaging device that detects light of three wavelength components incident from the outside and generates a color image signal.

As schematically shown in FIG. 1, the photoelectric conversion device 1 has a configuration in which a plurality of pixel structures 2 are two-dimensionally arranged on a semiconductor substrate. The pixel structure 2 includes: a buried region (first buried region) n1B configured to generate and accumulate electrons, which are carriers (signal charges) corresponding to an intensity of a blue light component (first wavelength component) of incident light at an incident surface 2a on which detection target light is incident; a floating diffusion layer n5B; a transfer gate TX1 arranged between the buried region n1B and the floating diffusion layer n5B; a buried region (third buried region) n1G configured to accumulate electrons corresponding to an intensity of a green light component (second wavelength component) of the incident light; a floating diffusion layer n5G; a transfer gate TX2 arranged between the buried region n1G and the floating diffusion layer n5G; a buried region (sixth buried region) n1R configured to accumulate electrons corresponding to an intensity of a red light component (third wavelength component) of the incident light; a floating diffusion layer n5R; and a transfer gate TX3 arranged between the buried region n1R and the floating diffusion layer n5R.

Hereinafter, a detailed laminated structure of the pixel structure 2 will be described with reference to FIGS. 2 and 3.

The pixel structure 2 includes: a P-type (second conductivity type) semiconductor substrate 3 such as a silicon substrate; a photoelectric conversion layer 4 that is a P-type epitaxial layer formed on the semiconductor substrate 3; and a metal layer 5 configured to block light from the outside. The photoelectric conversion layer 4 includes a main surface (first main surface) 4a close to the semiconductor substrate 3 and a main surface (second main surface) 4b extending along the main surface 4a and constituting the incident surface 2a covered with the metal layer 5. An opening 5a is formed at the center of the metal layer 5 covering one pixel structure 2, and the detection target light passes through the inside of the opening 5a and is incident on the center of the main surface 4b of the photoelectric conversion layer 4.

In a region corresponding to the inside of the opening 5a in the photoelectric conversion layer 4, a P-type semiconductor layer p1, a buried region (first buried region) n1B of an N-type (first conductivity type) having polarity opposite to that of the P-type, a P-type semiconductor layer p2, a buried region (second buried region) n3G of the N-type, a P-type semiconductor layer p3, and a buried region (fifth buried region) n4R of the N-type are buried and laminated in this order from the main surface 4b toward the main surface 4a. The buried region n3G is formed at a position deeper than the buried region n1B. The buried region n4R is formed at a position deeper than the buried region n1B and the buried region n3G. A part of the buried region n4R is formed to extend to the same layer as the P-type semiconductor layer p3.

The P-type semiconductor layer p1 and the buried region n1B constitute a first photodiode arranged near the main surface 4b. Therefore, the buried region n1B converts a blue light component within the light incident on the main surface 4b from the opening 5a into electrons and accumulates the electrons after the conversion.

The P-type semiconductor layer p2 and the buried region n3G constitute a second photodiode buried at a position deeper from the main surface 4b than the first photodiode. Therefore, the buried region n3G converts a green light component, which is a longer wavelength component than the blue light component, within the light incident on the main surface 4b from the opening 5a into electrons.

The P-type semiconductor layer p3 and the buried region n4R constitute a third photodiode buried at a position deeper from the main surface 4b than the first photodiode and the second photodiode. Therefore, the buried region n4R converts a red light component, which is a longer wavelength component than the green light component, within the light incident on the main surface 4b from the opening 5a into electrons.

Moreover, in the photoelectric conversion layer 4, in regions covered with the metal layer 5 outside the first to third photodiodes (regions indicated by reference signs n1G and n1R in FIG. 1), under the P-type semiconductor layer p1, the N-type buried region (third buried region) n1G and the P-type semiconductor layer p2 are laminated and the N-type buried region (sixth buried region) n1R and the P-type semiconductor layer p2 are also laminated. These buried regions n1G and n1R are formed in the same layer as the buried region n1B and are sandwiched between two P-type semiconductor layers. The buried region n1G is provided to accumulate electrons obtained by a conversion process of the buried region n3G, and the buried region n1R is provided to accumulate electrons obtained by a conversion process of the buried region n4R.

In addition, in the buried regions n1B and n1G, to reliably separate electrons due to the blue light component and electrons due to the green light component accumulated therein, a P-type buried region p5 that is in contact with the buried region n1B and the buried region n1G may be formed to form a potential barrier between the buried region n1B and the buried region n1G.

Additionally, in the photoelectric conversion layer 4, in a region sandwiched between the buried region n1G and the buried region n3G within the same layer as the P-type semiconductor layer p2, an N-type buried region (fourth buried region) n2G is formed in contact with a part of the buried region n1G and a part of the buried region n3G. Moreover, at the end portions of the buried region n2G, the buried region n3G, the P-type semiconductor layer p3, and the buried region n4R, a P-type semiconductor layer p4 is formed to extend across and contact these layers to form a potential barrier between adjacent pixel structures 2. With such a configuration, the buried region n2G is arranged between the buried region n1G and the buried region n3G to be sandwiched by the two P-type semiconductor layers p2 and p4 in a direction along the main surface 4b. The buried region n2G has a function of transferring electrons converted by the buried region n3G to the buried region n1G.

Here, an impurity concentration of the buried region n1G is higher than an impurity concentration of the buried region n2G. An impurity concentration of the buried region n2G is higher than an impurity concentration of the buried region n3G. Due to such features, the potential can be made to change monotonically in a region extending across the buried region n3G, the buried region n2G, and the buried region n1G. In addition, the buried region n2G is formed so that a length L_{G} between a junction surface with the buried region n1G and a junction surface with the buried region n3G in a direction perpendicular to the main surface 4b is equal to or greater than one-half of a width W_{G} sandwiched between the two P-type semiconductor layers p2 and p4. That is, the buried region n2G is formed to satisfy the following formula (1).${L}_{G} \geq \left(1/2\right) \cdot {W}_{G}$

Thereby, in the buried region n2G, a potential dip is unlikely to occur, and a potential that changes monotonically between the junction surface with the buried region n1G and the junction surface with the buried region n3G is generated.

Furthermore, in the photoelectric conversion layer 4, two N-type buried regions (seventh buried regions) n2R and n3R are formed in a region sandwiched between the buried region n1R and the buried region n4R in the same layer as the P-type semiconductor layer p2 and the buried region n3G so that they are in contact with a portion of the buried region n1R and a portion of the buried region n4R. The buried region (first sub-region) n3R is arranged closer to the buried region n4R, and the buried region (second sub-region) n2R is arranged closer to the buried region n1R. Moreover, at the end portions of the buried region n2R, the buried region n3R, and the buried region n4R, the P-type semiconductor layer p4 for forming a potential barrier between adjacent pixel structures 2 is formed to contact across these layers. Moreover, P-type semiconductor layers PW and p4 for forming potential barriers are formed between the buried regions n1R, n2R, and n3R and buried regions n1B and n3G. In this case, the P-type semiconductor layer p4 is formed at a depth equal to or shallower than the lower surface of the P-type semiconductor layer p3. With such a configuration, the buried regions n2R and n3R are arranged between the buried region n1R and the buried region n4R to be sandwiched by the P-type semiconductor layers p4 and PW in a direction along the main surface 4b. In addition, an equivalent arrangement effect can be obtained by omitting the P-type semiconductor layer p4 overlapping the P-type semiconductor layer PW, forming the P-type semiconductor layer PW to a depth overlapping the P-type semiconductor layer p3, and forming the P-type semiconductor layer p4 deeper than the lower surface of the buried region n4R.

Here, the impurity concentration of the buried region n1R is higher than the impurity concentrations of the buried regions n2R and n3R. The impurity concentration of the buried region n2R is higher than the impurity concentration of the buried region n3R. The impurity concentration of the buried region n3R is higher than the impurity concentration of the buried region n4R. Due to these features, the potential can be monotonically varied in a region extending across the buried regions n4R, n3R, n2R, and n1R. In addition, the buried regions n2R and n3R are formed so that the length L_{R} in a direction perpendicular to the main surface 4b of a region obtained by combining the buried regions n2R and n3R and a region of the buried region n4R sandwiched by the two P-type semiconductor layers p4 is three times or more the width W_{R} sandwiched by the two P-type semiconductor layers p4 and PW. That is, the buried regions n2R and n3R are formed to satisfy the following formula (2).${L}_{R} \geq 3 \geq {W}_{R}$

Thereby, in the buried regions n2R and n3R, a dip in potential is unlikely to occur, and a potential that monotonically changes between the junction surface with the buried region n1R and the junction surface with the buried region n4R is generated.

As shown in FIGS. 2 and 3, the photoelectric conversion device 1 further includes a signal generation unit 6G configured to generate a signal corresponding to a charge amount of electrons transferred from the buried region n1G to the floating diffusion layer n5G, a signal generation unit 6R configured to generate a signal corresponding to the charge amount of electrons transferred from the buried region n1R to the floating diffusion layer n5R, and a signal generation unit 6B configured to generate a signal corresponding to the charge amount of electrons transferred from the buried region n1B to the floating diffusion layer n5B.

The signal generation unit 6G includes a reset transistor 8, a transistor 9, a selection transistor 10, and a bias transistor 11. The reset transistor 8, the transistor 9, the selection transistor 10, and the bias transistor 11 are MOS transistors, and some of them may be formed on the same semiconductor substrate 3 as the plurality of pixel structures 2. A selection signal SL is supplied from the outside to the gate of the selection transistor 10. A reset signal RT is supplied from the outside to the gate of the reset transistor 8. A transfer signal is supplied from the outside to the transfer gate TX2. The floating diffusion layer n5G is configured so that a reset potential V_{DRT} can be applied from the outside via the reset transistor 8, and is connected to the gate of the transistor 9. One current terminal (for example, the source) of the transistor 9 is connected to a column line 7 via the selection transistor 10. A potential VDSF is applied from the outside to the other current terminal (for example, the drain) of the transistor 9. The transistor 9 serving as a source follower provides, to the column line 7 via the selection transistor 10, a potential corresponding to the charge amount of the floating diffusion layer n5G. A bias voltage Vbias is applied from the outside to the gate of the bias transistor 11, and the drain of the bias transistor 11 is connected to the column line 7. The bias transistor 11 is a current source common to column lines 7 for supplying a drain current to the transistor 9 of each pixel selected by the selection transistor 10.

The signal generation unit 6G having the above-described configuration generates a first signal indicating a reset level and a second signal indicating a signal level superimposed on the reset level as follows. First, the reset signal RT is supplied to the reset transistor 8, and the floating diffusion layer n5G is reset. This reset potential is read in an external readout circuit via the transistor 9. Subsequently, the transfer signal is supplied to the transfer gate TX2, and electrons are transferred from the buried region n1G to the floating diffusion layer n5G. Also, a signal level corresponding to the charge amount of the transferred electrons is read in the external readout circuit via the transistor 9. In this manner, the signal generation unit 6G can generate the first signal indicating the reset level and the second signal indicating the signal level superimposed on the reset level.

Likewise, each of the signal generation units 6R and 6B includes the reset transistor 8, the transistor 9, the selection transistor 10, and the bias transistor 11. The configurations and operations of the signal generation units 6R and 6B are similar to those of the signal generation unit 6G. The signal generation unit 6R generates the first signal indicating the reset level and the second signal indicating the signal level superimposed on the reset level and corresponding to the charge amount of electrons transferred to the floating diffusion layer n5R. The signal generation unit 6B generates the first signal indicating the reset level and the second signal indicating the signal level superimposed on the reset level and corresponding to the charge amount of electrons transferred to the floating diffusion layer n5B.

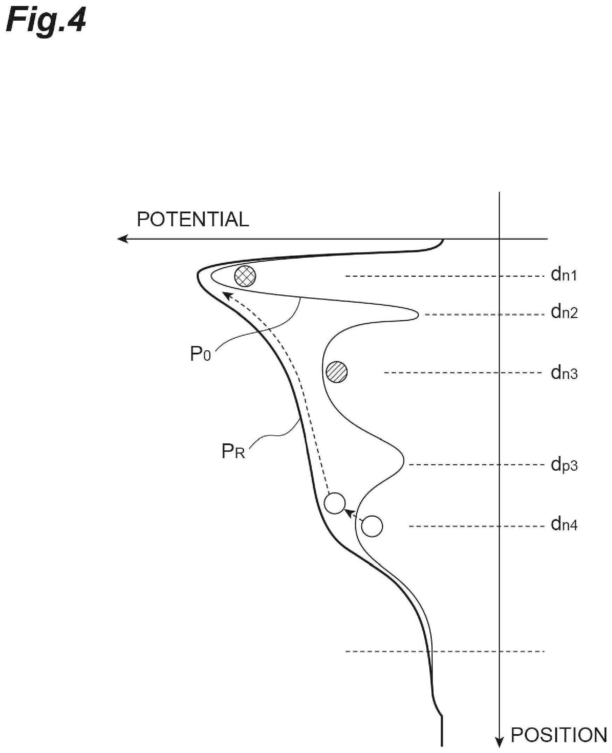

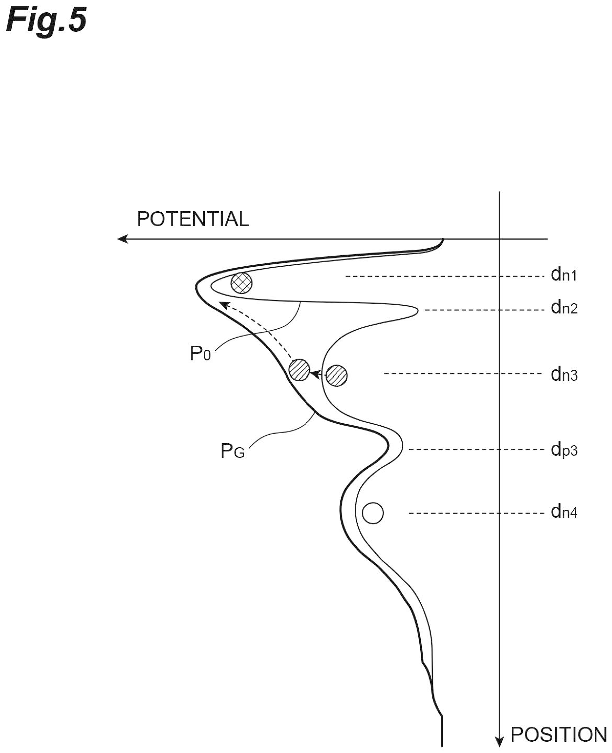

The potential distribution in the depth direction in the pixel structure 2 will be described with reference to FIGS. 4 and 5. In FIG. 4, a potential distribution P₀ along a direction perpendicular to the main surface 4b across the first to third photodiodes in the photoelectric conversion layer 4 of the pixel structure 2 and a potential distribution P_{R} along a direction perpendicular to the main surface 4b across the buried regions n1R, n2R, n3R, and n4R in the photoelectric conversion layer 4 are shown. In FIG. 5, a potential distribution P₀ along a direction perpendicular to the main surface 4b across the first to third photodiodes in the photoelectric conversion layer 4 of the pixel structure 2 and a potential distribution P_{G} along a direction perpendicular to the main surface 4b across the buried regions n1G, n2G, and n3G in the photoelectric conversion layer 4 are shown. Here, the depth corresponding to the buried regions n1G and n1R is shown at a position dₙ₁, the depth corresponding to the buried regions n2G and n2R is shown at a position dₙ₂, the depth corresponding to the buried regions n3G and n3R is shown at a position dₙ₃, the depth corresponding to the upper layer of the P-type semiconductor layer p3 and the buried region n4R is shown at a position dₚ₃, and the depth corresponding to the lower layer of the buried region n4R is shown at a position dₙ₄.

As shown in FIG. 4, in the potential distribution P_{R} on the electron transfer path extending across the buried regions n1R, n2R, n3R, and n4R, a potential that monotonically increases from the position dₙ₄ to the position dₙ₁ is formed. In particular, because the impurity concentration is set to increase stepwise from the position dₙ₄ to the position dₙ₁ and the buried regions n2R and n3R are formed to satisfy the above formula (2), a monotonic slope is produced in the potential distribution P_{R} without forming a dip that partially rises. Moreover, the depletion of the electron transfer path extending across the buried regions n1R, n2R, n3R, and n4R is also realized, and, as a result, noise in the signal read in accordance with the charge amount transferred to the buried region n1R can be reduced.

Moreover, as shown in FIG. 5, in the potential distribution P_{G} on the electron transfer path extending across the buried regions n1G, n2G, and n3G, a potential that monotonically increases from the position dₙ₃ to the position dₙ₁ is formed. In particular, because the impurity concentration is set to increase stepwise from the position dₙ₃ to the position dₙ₁ and the buried region n2G is formed to satisfy the above formula (1), a monotonic slope is produced in the potential distribution P_{G} without forming a dip that partially rises. Moreover, the depletion of the electron transfer path extending across the buried regions n1G, n2G, and n3G is also realized, and, as a result, noise in the signal read in accordance with the charge amount transferred to the buried region n1G can be reduced.

The functions and effects of the photoelectric conversion device 1 described above will now be described.

According to the photoelectric conversion device 1, a blue light component among the components of light incident from the main surface 4b of the photoelectric conversion layer 4 is converted into electrons in the N-type buried region n1B, and the electrons after the conversion are accumulated. In addition, a green light component among the components of light incident from the main surface 4b of the photoelectric conversion layer 4 is converted into electrons in the N-type buried region n3G, and the electrons after the conversion are accumulated in the N-type buried region n1G via the N-type buried region n2G that is in contact with the buried region n3G and the buried region n1G. Here, the buried region n2G is sandwiched by the two P-type semiconductor layers p2 and p4, and the impurity concentration is set to increase in the order of the buried region n3G, the buried region n2G, and the buried region n1G. Thereby, in the potential distribution P_{G} of the electron transfer path from the buried region n3G to the buried region n1G, a dip is unlikely to occur and the potential is formed to monotonically change, so that electrons can be transferred at high speed from the buried region n3G to the buried region n1G. As a result, it becomes possible to increase the speed of detection of electrons accumulated in accordance with light of two wavelength components. Moreover, the depletion of the electron transfer path extending across the buried regions n1G, n2G, and n3G is also realized, and, as a result, noise in the signal read in accordance with the charge amount transferred to the buried region n1G can also be reduced.

Furthermore, the photoelectric conversion layer 4 of the present embodiment includes the N-type buried region n4R configured to convert light of a red light component incident on the main surface 4b into electrons, the N-type buried region n1R configured to accumulate the electrons obtained by a conversion process of the buried region n4R, and N-type buried regions n2R and n3R configured to come into contact with the buried region n4R and the buried region n1R and provided between the buried region n4R and the buried region n1R to be sandwiched by the two P-type semiconductor layers p4 and PW, the buried regions n2R and n3R transferring the electrons obtained by the conversion process of the buried region n4R to the buried region n1R. In such a configuration, among the components of light incident from the main surface 4b of the photoelectric conversion layer 4, a red light component is converted into electrons in the buried region n4R, and the electrons after the conversion are accumulated in the buried region n1R via the buried regions n2R and n3R that are in contact with the buried region n4R and the buried region n1R. Here, the buried regions n2R and n3R are sandwiched by the two P-type semiconductor layers, and the impurity concentration is set to increase in the order of the buried region n4R, the buried region n3R, the buried region n2R, and the buried region n1R. Thereby, in the potential distribution P_{R} of the electron transfer path from the buried region n4R to the buried region n1R, a dip is unlikely to occur and the potential is formed to change monotonically, so that electrons can be transferred at high speed from the buried region n4R to the buried region n1R. As a result, it becomes possible to increase the speed of detection of electrons accumulated in accordance with light of three wavelength components. Moreover, the depletion of the electron transfer path extending across the buried regions n1R, n2R, n3R, and n4R is also realized, and, as a result, noise in the signal read in accordance with the charge amount transferred to the buried region n1R can also be reduced.

Moreover, the buried region n2G is formed to satisfy the above formula (1). In this case, the occurrence of a potential dip in the potential distribution P_{G} of the electron transfer path from the buried region n3G to the buried region n1G can be prevented. As a result, electrons can be transferred at high speed from the buried region n3G to the buried region n1G. In general, when an N-type region sandwiched by P-type regions has a large width and it is desired to form a monotonic potential slope, it is necessary to reduce the impurity concentration. On the other hand, according to the buried region n2G formed to satisfy the above formula (1), a potential having a monotonic slope can be formed from the buried region n3G to the buried region n1G while maintaining a relatively high impurity concentration. As a result, the movement of electrons in the buried regions n3G, n2G, and n1G can be promoted, and the transfer speed of signal charges can be increased.

Moreover, the buried regions n2R and n3R are formed to satisfy the above formula (2). In this case, the occurrence of a potential dip in the potential distribution P_{R} of the electron transfer path from the buried region n4R to the buried region n1R can be prevented. As a result, electrons can be transferred at high speed from the buried region n4R to the buried region n1R. According to the buried regions n2R and n3R formed to satisfy the above formula (2), a potential having a monotonic slope can be formed from the buried region n4R to the buried region n1R while maintaining a relatively high impurity concentration. As a result, the movement of electrons in the buried regions n4R, n3R, n2R, and n1R can be promoted, and the transfer speed of signal charges can be increased.

The present invention is not limited to the embodiment described above. The configuration of the above embodiment may be modified in various ways.

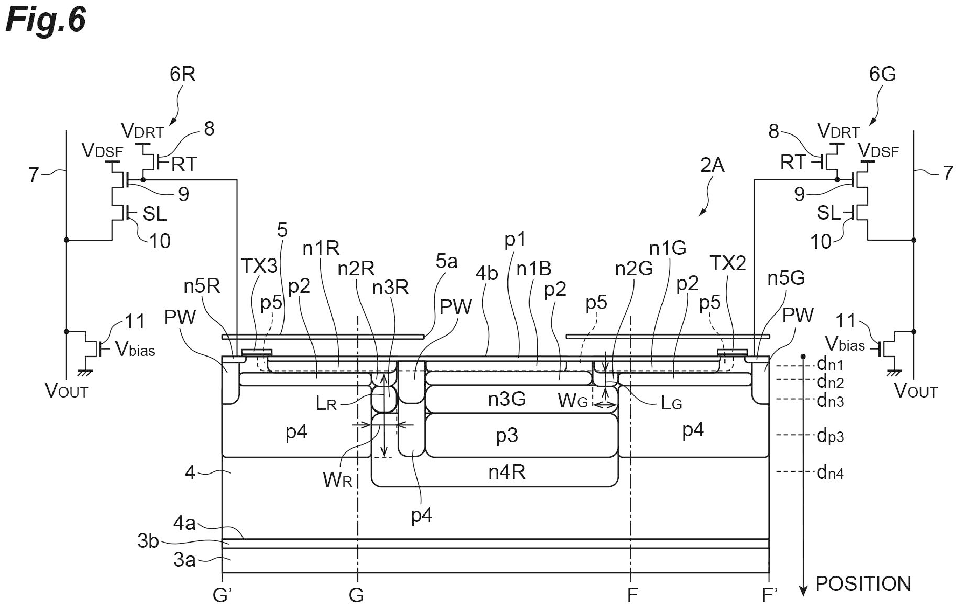

Moreover, in the above-described embodiment, the P-type photoelectric conversion layer 4 is formed on the P-type semiconductor substrate 3. As a modification example, the photoelectric conversion layer 4 may be laminated on an N-type semiconductor substrate with an epitaxial layer having a higher concentration than the photoelectric conversion layer 4 interposed therebetween. FIG. 6 is a cross-sectional view of a pixel structure 2A according to a modification example. In the pixel structure 2A, an N-type semiconductor substrate 3a that is in contact with the main surface 4a via a P-type epitaxial layer 3b having a higher impurity concentration than the photoelectric conversion layer 4 is provided. By using such an N-type semiconductor substrate, low crosstalk and low dark current can be realized.

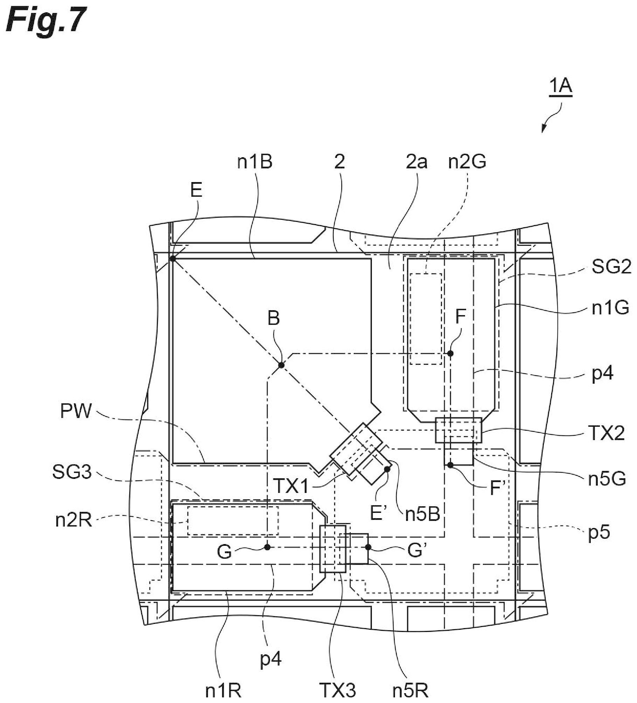

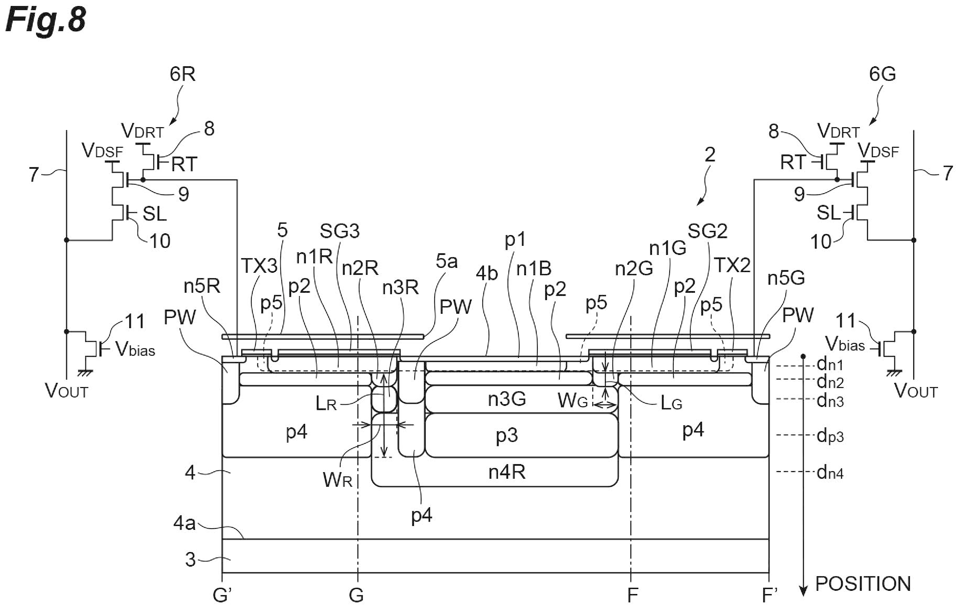

In the above-described embodiment, a three-layer structure of a P-type semiconductor layer, an N-type semiconductor layer, and a P-type semiconductor layer was used as a region for accumulating electrons after conversion from light of three wavelength components (for example, a region having a three-layer structure of the P-type semiconductor layer p1, the buried region n1G, and the P-type semiconductor layer p2). As a modification example, the region for accumulating electrons may adopt an accumulation gate structure including a metal layer, an insulating layer, and a semiconductor layer. FIG. 7 is a plan view of a photoelectric conversion device 1A according to a modification, and FIG. 8 is a cross-sectional view of the photoelectric conversion device 1A. In the photoelectric conversion device 1A, accumulation gates SG2 and SG3 are formed on the outermost surface of the photoelectric conversion layer 4 via a gate insulating film. That is, in the photoelectric conversion layer 4, the buried regions n1G and n1R are formed at the outermost surface, the accumulation gate SG2 that is a metal layer is formed via a gate insulating film in a surface region that two-dimensionally includes the buried region n1G, and the accumulation gate SG3 that is a metal layer is formed via a gate insulating film in a surface region that two-dimensionally includes the buried region n1R. Thereby, the number of electrons that can be accumulated in the buried regions n1G and n1R can be increased. During the accumulation of photoelectrons, positive charges are applied to the accumulation gates SG2 and SG3 to deepen the potential well, thereby increasing the number of electrons that can be accumulated. When electrons are transferred from the buried region n1G to the floating diffusion layer n5G or from the buried region n1R to the floating diffusion layer n5R using the transfer gates TX2 and TX3, negative charges are applied to the accumulation gates SG2 and SG3 to promote electron transfer.

Although the P-type semiconductor layer p1 serving as a pinning layer is also formed on the surfaces of the buried regions n1G and n1R (FIG. 2) in a configuration in which an accumulation gate is not formed, the P-type semiconductor layer p1 is formed in a self-aligned manner in regions other than the accumulation gate after the formation of the accumulation gate (FIG. 8) in a configuration in which an accumulation gate is formed.

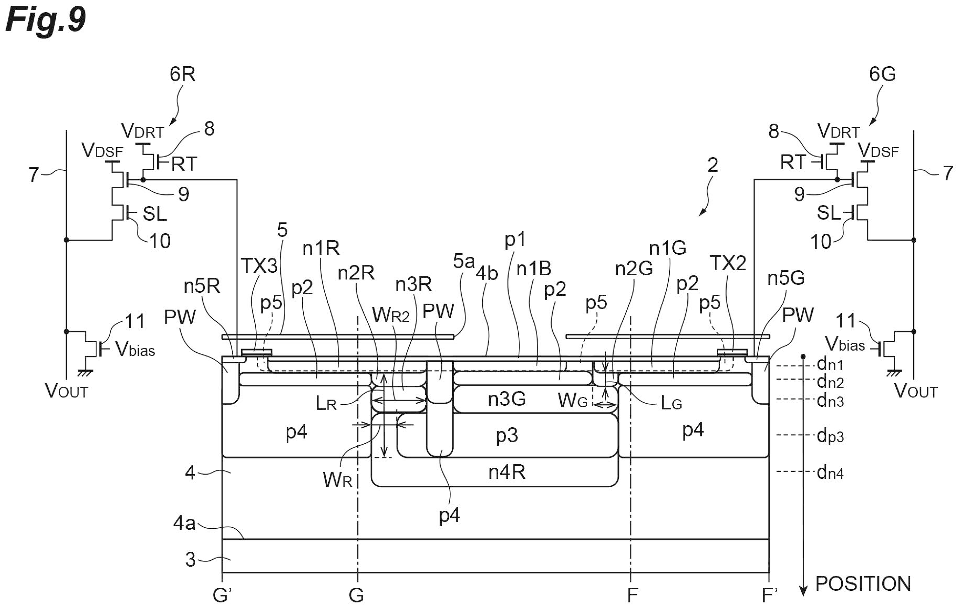

FIG. 9 is a cross-sectional view of a photoelectric conversion device according to another modification example. In this modification example, compared with the configuration shown in FIG. 2, the sizes of the buried regions n2R and n3R and the positions of the P-type semiconductor layers p4 and PW are different. In this modification example, the positions of the P-type semiconductor layers p4 and PW are shifted from a point G toward a point B, and the widths of the buried regions n2R and n3R are expanded toward the point B side. More specifically, a width W_{R2}, in a direction parallel to the main surface 4b, of a region sandwiched by the two P-type semiconductor layers p4 within the buried regions n2R and n3R is set to be larger than a width W_{R}, in a direction parallel to the main surface 4b, of a region sandwiched by the two P-type semiconductor layers p3 and p4 within the buried region n4R. Specifically, the width W_{R2} is set to satisfy the following formula to be equal to or greater than 1.5 times the width W_{R} and equal to or less than 2 times the width W_{R}.$1 {. 5 W}_{R} \leq {W}_{R 2} \leq {2 W}_{R}$

According to such a modification example, the occurrence of a potential dip in the potential distribution of the carrier transfer path from the buried region n4R to the buried region n1R can be prevented. As a result, carriers can be transferred at high speed from the buried region n4R to the buried region n1R.

Here, in the present embodiment, the photoelectric conversion layer may include: a fifth buried region of the first conductivity type buried at a position deeper from the second main surface than the first buried region and the second buried region and configured to convert light of a third wavelength component incident on the second main surface into carriers; a sixth buried region of the first conductivity type buried in the same layer as the first buried region at the second main surface and configured to accumulate carriers obtained by the conversion process of the fifth buried region; and a seventh buried region of the first conductivity type configured to come into contact with the fifth buried region and the sixth buried region and provided to be sandwiched between two regions of the second conductivity type between the fifth buried region and the sixth buried region, the seventh buried region being configured to transfer the carriers obtained by a conversion process of the fifth buried region to the sixth buried region, wherein an impurity concentration of the sixth buried region may be set to be higher than an impurity concentration of the seventh buried region, and an impurity concentration of the seventh buried region may be set to be higher than an impurity concentration of the fifth buried region. In such a configuration, among the components of light incident from the second main surface of the photoelectric conversion layer, a third wavelength component is converted into carriers in the fifth buried region of the first conductivity type, and the carriers after the conversion are accumulated in the sixth buried region of the first conductivity type via the seventh buried region of the first conductivity type that is in contact with the fifth buried region and the sixth buried region. Here, the seventh buried region is sandwiched by two regions of the second conductivity type, and the impurity concentration is set to increase in the order of the fifth buried region, the seventh buried region, and the sixth buried region. Thereby, in the potential distribution of the carrier transfer path from the fifth buried region to the sixth buried region, a dip is unlikely to occur and the potential is formed to change monotonically, so that carriers can be transferred at high speed from the fifth buried region to the sixth buried region. As a result, it becomes possible to increase the speed of detection of carriers accumulated in accordance with light of three wavelength components.

Moreover, the seventh buried region may include a first sub-region closer to the fifth buried region and a second sub-region closer to the sixth buried region, and an impurity concentration of the second sub-region may be set to be higher than an impurity concentration of the first sub-region. In this case, a potential that monotonically changes can be easily formed in the potential distribution of the carrier transfer path in the seventh buried region, and carriers can be transferred more rapidly from the fifth buried region to the sixth buried region.

Moreover, a length of the fourth buried region in a direction perpendicular to the second main surface may be set to be one-half or more of a width between the two regions of the second conductivity type. In this case, the occurrence of a potential dip in the potential distribution of the carrier transfer path from the second buried region to the third buried region can be prevented. As a result, carriers can be transferred at high speed from the second buried region to the third buried region.

Moreover, a length, in a direction perpendicular to the second main surface, of a region obtained by combining the seventh buried region and a region of the fifth buried region sandwiched between the two regions of the second conductivity type may be set to be three times or more a width between the two regions of the second conductivity type. In this case, the occurrence of a potential dip in the potential distribution of the carrier transfer path from the fifth buried region to the sixth buried region can be prevented. As a result, carriers can be transferred at high speed from the fifth buried region to the sixth buried region.

Moreover, the semiconductor substrate may include a semiconductor substrate of the first conductivity type that comes into contact with the first main surface via an epitaxial layer of the second conductivity type having a higher impurity concentration than the photoelectric conversion layer.

Moreover, the sixth buried region may form an outermost surface of the photoelectric conversion layer, and an accumulation gate may be formed via a gate insulating film in a surface region including the sixth buried region. Moreover, the third buried region may form an outermost surface of the photoelectric conversion layer, and an accumulation gate may be formed via a gate insulating film in a surface region including the third buried region.

Moreover, a width, in a direction parallel to the second main surface, of a region of the seventh buried region sandwiched between the two regions of the second conductivity type may be set to be larger than a width, in a direction parallel to the second main surface, of a region of the fifth buried region sandwiched between two regions of the second conductivity type. In this case, the occurrence of a potential dip in the potential distribution of the carrier transfer path from the fifth buried region to the sixth buried region can be prevented. As a result, carriers can be transferred at high speed from the fifth buried region to the sixth buried region.

Moreover, a width, in a direction parallel to the second main surface, of a region of the seventh buried region sandwiched between two regions of the second conductivity type may be set to be equal to or greater than 1.5 times and equal to or less than 2 times a width, in a direction parallel to the second main surface, of a region of the fifth buried region sandwiched between two regions of the second conductivity type. In this case as well, the occurrence of a potential dip in the potential distribution of the carrier transfer path from the fifth buried region to the sixth buried region can be prevented. As a result, carriers can be transferred at high speed from the fifth buried region to the sixth buried region.

A photoelectric conversion device of an embodiment is [1] "a photoelectric conversion device including:
a semiconductor substrate; and
a photoelectric conversion layer formed on the semiconductor substrate and having a first main surface close to the semiconductor substrate and a second main surface extending along the first main surface,
wherein the photoelectric conversion layer includes:
   a first buried region of a first conductivity type buried at the second main surface and configured to convert light of a first wavelength component incident on the second main surface into carriers and accumulate the carriers after the conversion;
   a second buried region of the first conductivity type buried at a position deeper than the first buried region from the second main surface and configured to convert light of a second wavelength component incident on the second main surface into carriers;
   a third buried region of the first conductivity type buried in the same layer as the first buried region at the second main surface and configured to accumulate carriers obtained by a conversion process of the second buried region; and
   a fourth buried region of the first conductivity type configured to come into contact with the second buried region and the third buried region and provided to be sandwiched between two regions of a second conductivity type between the second buried region and the third buried region, the fourth buried region being configured to transfer the carriers obtained by the conversion process of the second buried region to the third buried region,
   wherein an impurity concentration of the third buried region is set to be higher than an impurity concentration of the fourth buried region, and an impurity concentration of the fourth buried region is set to be higher than an impurity concentration of the second buried region."

A photoelectric conversion device of an embodiment may be [2] "the photoelectric conversion device according to the above-described [1], wherein the photoelectric conversion layer further includes:
a fifth buried region of the first conductivity type buried at a position deeper from the second main surface than the first buried region and the second buried region and configured to convert light of a third wavelength component incident on the second main surface into carriers;
a sixth buried region of the first conductivity type buried in the same layer as the first buried region at the second main surface and configured to accumulate carriers obtained by the conversion process of the fifth buried region; and
a seventh buried region of the first conductivity type configured to come into contact with the fifth buried region and the sixth buried region and provided to be sandwiched between two regions of the second conductivity type between the fifth buried region and the sixth buried region, the seventh buried region being configured to transfer the carriers obtained by a conversion process of the fifth buried region to the sixth buried region,
wherein an impurity concentration of the sixth buried region is set to be higher than an impurity concentration of the seventh buried region, and an impurity concentration of the seventh buried region is set to be higher than an impurity concentration of the fifth buried region."

A photoelectric conversion device of an embodiment may be [3] "the photoelectric conversion device according to the above-described [2],
wherein the seventh buried region includes a first sub-region closer to the fifth buried region and a second sub-region closer to the sixth buried region, and
wherein an impurity concentration of the second sub-region is set to be higher than an impurity concentration of the first sub-region."

A photoelectric conversion device of an embodiment may be [4] "the photoelectric conversion device according to any one of the above-described [1] to [3], wherein a length of the fourth buried region in a direction perpendicular to the second main surface is set to be one-half or more of a width between the two regions of the second conductivity type."

A photoelectric conversion device of an embodiment may be [5] "the photoelectric conversion device according to the above-described [2] or [3], wherein a length, in a direction perpendicular to the second main surface, of a region obtained by combining the seventh buried region and a region of the fifth buried region sandwiched between the two regions of the second conductivity type is set to be three times or more a width between the two regions of the second conductivity type."

A photoelectric conversion device of an embodiment may be [6] "the photoelectric conversion device according to any one of the above-described [1] to [5], wherein the semiconductor substrate includes a semiconductor substrate of the first conductivity type that comes into contact with the first main surface via an epitaxial layer of the second conductivity type having a higher impurity concentration than the photoelectric conversion layer."

A photoelectric conversion device of an embodiment may be [7] "the photoelectric conversion device according to the above-described [2], [3], or [5], wherein the sixth buried region forms an outermost surface of the photoelectric conversion layer, and an accumulation gate is formed via a gate insulating film in a surface region including the sixth buried region."

A photoelectric conversion device of an embodiment may be [8] "the photoelectric conversion device according to any one of the above-described [1] to [7], wherein the third buried region forms an outermost surface of the photoelectric conversion layer, and an accumulation gate is formed via a gate insulating film in a surface region including the third buried region."

A photoelectric conversion device of an embodiment may be [9] "the photoelectric conversion device according to the above-described [2] or [3], wherein a width, in a direction parallel to the second main surface, of a region of the seventh buried region sandwiched between the two regions of the second conductivity type is set to be larger than a width, in a direction parallel to the second main surface, of a region of the fifth buried region sandwiched between two regions of the second conductivity type."

A photoelectric conversion device of an embodiment may be [10] "the photoelectric conversion device according to the above-described [9], wherein a width, in a direction parallel to the second main surface, of a region of the seventh buried region sandwiched between two regions of the second conductivity type is set to be equal to or greater than 1.5 times and equal to or less than 2 times a width, in a direction parallel to the second main surface, of a region of the fifth buried region sandwiched between two regions of the second conductivity type."

### Reference Signs List

1, 1A Photoelectric conversion device, 3, 3a Semiconductor substrate, 4 Photoelectric conversion layer, 4a Main surface (first main surface), 4b Main surface (second main surface), n1B Buried region (first buried region), n1G Buried region (third buried region), n1R Buried region (sixth buried region), n2G Buried region (fourth buried region), n2R, n3R Buried region (seventh buried region), n2R Buried region (second sub-region), n3G Buried region (second buried region), n3R Buried region (first sub-region), n4R Buried region (fifth buried region), SG2, SG3 Accumulation gate, W_{G}, W_{R}, W_{R2} Width, L_{G}, L_{R} Length

## Claims

1. A photoelectric conversion device comprising:
a semiconductor substrate; and
a photoelectric conversion layer formed on the semiconductor substrate and having a first main surface close to the semiconductor substrate and a second main surface extending along the first main surface,
wherein the photoelectric conversion layer includes:
a first buried region of a first conductivity type buried at the second main surface and configured to convert light of a first wavelength component incident on the second main surface into carriers and accumulate the carriers after the conversion;
a second buried region of the first conductivity type buried at a position deeper than the first buried region from the second main surface and configured to convert light of a second wavelength component incident on the second main surface into carriers;
a third buried region of the first conductivity type buried in the same layer as the first buried region at the second main surface and configured to accumulate carriers obtained by a conversion process of the second buried region; and
a fourth buried region of the first conductivity type configured to come into contact with the second buried region and the third buried region and provided to be sandwiched between two regions of a second conductivity type between the second buried region and the third buried region, the fourth buried region being configured to transfer the carriers obtained by the conversion process of the second buried region to the third buried region,
wherein an impurity concentration of the third buried region is set to be higher than an impurity concentration of the fourth buried region, and an impurity concentration of the fourth buried region is set to be higher than an impurity concentration of the second buried region.

2. The photoelectric conversion device according to claim 1, wherein the photoelectric conversion layer further includes:
a fifth buried region of the first conductivity type buried at a position deeper from the second main surface than the first buried region and the second buried region and configured to convert light of a third wavelength component incident on the second main surface into carriers;
a sixth buried region of the first conductivity type buried in the same layer as the first buried region at the second main surface and configured to accumulate carriers obtained by the conversion process of the fifth buried region; and
a seventh buried region of the first conductivity type configured to come into contact with the fifth buried region and the sixth buried region and provided to be sandwiched between two regions of the second conductivity type between the fifth buried region and the sixth buried region, the seventh buried region being configured to transfer the carriers obtained by a conversion process of the fifth buried region to the sixth buried region,
wherein an impurity concentration of the sixth buried region is set to be higher than an impurity concentration of the seventh buried region, and an impurity concentration of the seventh buried region is set to be higher than an impurity concentration of the fifth buried region.

3. The photoelectric conversion device according to claim 2,
wherein the seventh buried region includes a first sub-region closer to the fifth buried region and a second sub-region closer to the sixth buried region, and
wherein an impurity concentration of the second sub-region is set to be higher than an impurity concentration of the first sub-region.

4. The photoelectric conversion device according to any one of claims 1 to 3, wherein a length of the fourth buried region in a direction perpendicular to the second main surface is set to be one-half or more of a width between the two regions of the second conductivity type.

5. The photoelectric conversion device according to claim 2 or 3, wherein a length, in a direction perpendicular to the second main surface, of a region obtained by combining the seventh buried region and a region of the fifth buried region sandwiched between the two regions of the second conductivity type is set to be three times or more a width between the two regions of the second conductivity type.

6. The photoelectric conversion device according to any one of claims 1 to 5, wherein the semiconductor substrate includes a semiconductor substrate of the first conductivity type that comes into contact with the first main surface via an epitaxial layer of the second conductivity type having a higher impurity concentration than the photoelectric conversion layer.

7. The photoelectric conversion device according to claim 2, 3, or 5, wherein the sixth buried region forms an outermost surface of the photoelectric conversion layer, and an accumulation gate is formed via a gate insulating film in a surface region including the sixth buried region.

8. The photoelectric conversion device according to any one of claims 1 to 7, wherein the third buried region forms an outermost surface of the photoelectric conversion layer, and an accumulation gate is formed via a gate insulating film in a surface region including the third buried region.

9. The photoelectric conversion device according to claim 2 or claim 3, wherein a width, in a direction parallel to the second main surface, of a region of the seventh buried region sandwiched between the two regions of the second conductivity type is set to be larger than a width, in a direction parallel to the second main surface, of a region of the fifth buried region sandwiched between two regions of the second conductivity type.

10. The photoelectric conversion device according to claim 9, wherein a width, in a direction parallel to the second main surface, of a region of the seventh buried region sandwiched between two regions of the second conductivity type is set to be equal to or greater than 1.5 times and equal to or less than 2 times a width, in a direction parallel to the second main surface, of a region of the fifth buried region sandwiched between two regions of the second conductivity type.
